# EUROPEAN PATENT APPLICATION

(11) **EP 3 715 699 A1**
(43) Date of publication of application: **30.09.2020**
(21) Application number: 19166096.8
(22) Date of filing: 29.03.2019
(51) Int. Cl.: F21K 9/232, F21V 23/06, H01L 33/56, H05K 3/32

(54) **LED LIGHT BULB**

(71) Applicant: GaN Power Technology Co., Ltd., Taichung City 40744 (TW)
(72) Inventor: WANG, Hsing Yeh, 40744 Taichung City (TW); YEN, Tsung Hsien, 40744 Taichung City (TW)
(74) Representative: Cabinet Chaillot

(57) **Abstract**

The LED light bulb includes a housing (1), a bulb holder (2), at least one LED illuminating member (3) disposed in the housing for comprehensive and effective illumination, and a driver board (4) that is disposed in the bulb holder and has a gallium nitride transistor (41). The LED illuminating member includes a plurality of LED chips (31), without reflectors, packaged and arranged in a staggering manner for comprehensive and effective illumination. Through the gallium nitride transistor having the advantages of high efficiency, high frequency and low load cycle power conversion, the LED illuminating member has better illuminating performance and can reduce the size of its driver board. The driver board can be installed in a conventional lamp, without the limitation of the size of the driver board.

## Description

### FIELD OF THE INVENTION

The present invention relates to a light bulb using LEDs as an illuminating member, and more particularly to an LED light bulb which can emit light in a comprehensive manner.

### BACKGROUND OF THE INVENTION

An LED functioning as a solid-state cold light source has become the mainstream product in the field of lighting because of its advantages of energy-saving, environmental protection and long service life. However, the existing LED lamps, especially LED bulbs, are equipped with a substrate or post in a housing for its brightness. The substrate or post is provided with a plurality of LED chips. A driving circuit provided in the lamp holder is configured to drive the LED chips to emit light. However, the light-emitting direction of the LED chips disposed on the substrate is limited. Although the LED chips disposed on the post has improved overall illumination, but the heat dissipation effect is poor. The LED chip uses sapphire as a lining. Coating a reflector under the lining results in poor illumination of the LED chip.

Furthermore, the driving circuit uses a conventional transistor for driving the LED chip to emit light. The transistor is large in size, so the size of the circuit board of the driving circuit cannot be reduced. As a result, the circuit board cannot be mounted inside the lamp holder. It is necessary to provide a seat between the housing and the lamp holder for installing the circuit board. Thus, the size of the LED bulb is much larger than that of a conventional tungsten bulb, and it cannot be installed in a conventional lamp.

Accordingly, the inventor of the present invention has devoted himself based on his many years of practical experiences to solve these problems.

### SUMMARY OF THE INVENTION

The primary object of the present invention is to provide an LED light bulb that uses a transparent substrate and an LED illuminating member composed of a plurality of LED chips, without reflectors, packaged and arranged in a staggering manner for comprehensive and effective illumination.

Another object of the present invention is to provide an LED light bulb that uses a driver board having a gallium nitride transistor. Because the gallium nitride transistor has the advantages of high efficiency, high frequency and low load cycle power conversion, the LED illuminating member has better illuminating performance and can reduce the size of its driver board for being mounted in a bulb holder. It makes the bulb design the same size as a conventional bulb without the limitation of the size of the driver board, such that the driver board can be installed in a conventional lamp.

A further object of the present invention is that one side of the driver board is coated with a layer of heat dissipation adhesive to form a heat insulation layer. The heat insulation layer is used to fix the driver board in the bulb holder and block the heat energy generated when the LED illuminating member emits light, thereby prolonging the service life of the driver board.

In order to achieve the above objects, an LED light bulb is provided. The LED light bulb comprises a housing, a bulb holder, at least one LED illuminating member disposed in the housing for comprehensive and effective illumination, and a driver board that is disposed in the bulb holder and has a gallium nitride transistor. The housing is a hollow sphere made of a light-permeable material. The bulb holder is disposed at one end of the housing. The bulb holder has an end portion and a threaded portion to form a positive terminal and a negative terminal for supplying power. The LED illuminating member includes a plurality of LED chips without reflectors. The LED chips are arranged on a transparent substrate in a staggering manner. A positive conductive wire and a negative conductive wire are disposed on the transparent substrate. The LED chips and the positive conductive wire are electrically connected to the negative conductive wire through a plurality of wires. One end of each of the positive conductive wire and the negative conductive wire is connected to a conductive pin that is fixed by a conductive adhesive composed of high-temperature silica gel, copper powder and palladium powder. The conductive pin is further electrically connected to the driver board. Positive and negative power input portions of the driver board are connected to the threaded section and the end portion of the bulb holder through wires. When the bulb holder is connected with a power source, the LED illuminating member is driven by the driver board to emit light.

### BRIEF DESCRIPTION OF THE DRAWINGS

FIG. 1 is a schematic view showing the structure of the present invention; and
FIG. 2 is a schematic view showing the comprehensive illumination of the present invention.

### DETAILED DESCRIPTION OF THE PREFERRED EMBODIMENTS

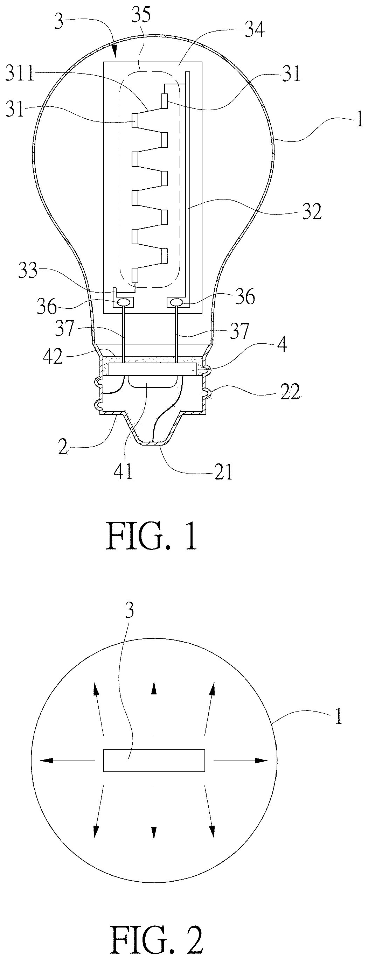

Referring to FIG. 1, the present invention discloses an LED light bulb. The LED light bulb comprises a housing 1, a bulb holder 2, at least one LED illuminating member 3 disposed in the housing 1 for comprehensive and effective illumination, and a driver board 4 that is disposed in the bulb holder 2 and has a gallium nitride transistor (GAN FET) 41.

The housing 1 is a hollow sphere made of a light-permeable material. In general, it is made of a glass material. The bulb holder 2 is disposed at one end of the housing 1. The bulb holder 2 has an end portion 21 and a threaded portion 22 to form a positive terminal and a negative terminal for supplying power.

The LED illuminating member 3 includes a plurality of LED chips 31 without reflectors. The LED chips 31 are arranged on a transparent substrate 34 in a staggering manner. A positive conductive wire 32 and a negative conductive wire 33 are disposed on the transparent substrate 34. The LED chips 31 and the positive conductive wire 32 are electrically connected to the negative conductive wire 33 through a plurality of wires 311. A region of two surfaces of the transparent substrate 34, covered by the LED chips 31, is coated with an encapsulant 35 which can increase brightness, such as fluorescent adhesive. One end of each of the positive conductive wire 32 and the negative conductive wire 33 is connected to a conductive pin 37 that is fixed by a conductive adhesive 36. The conductive adhesive 36 is made by adding copper powder and palladium powder to high-temperature silica gel. The conductive adhesive 36 is heated to bond the conductive pin 37 to the transparent substrate 34 and electrically connected to the positive and negative conductive wires 32, 33. The conductive adhesive 36 allows the conductive pin 37 to be fixed on the transparent substrate 34 stably and can withstand a temperature of 170 degrees or higher.

The driver board 4 having the gallium nitride transistor 41 is electrically connected to the conductive pin 37 of the LED illuminating member 3. One side of the driver board 4, corresponding to the LED illuminating member 3, is coated with a layer of heat dissipation adhesive to form a heat insulation layer 42. The periphery of the heat insulation layer 42 fills the gap between the driver board 4 and the inner wall of the bulb holder 2. The heat insulation layer 42 is used to fix the driver board 4 in the bulb holder 2 and block the heat energy generated when the LED illuminating member 3 emits light. The positive and negative power input portions of the driver board 4 are connected to the threaded section 22 and the end portion 21 of the bulb holder 2 through wires. When the bulb holder 2 is connected with a power source, the LED illuminating member 3 is driven by the driver board 4 to emit light.

As known from the foregoing description, the advantage of the present invention is that the LED illuminating member 3 is composed of a plurality of LED chips 31, without reflectors, packaged and arranged in a staggering manner, so that the each LED chip 31 can emit light on its circumference and can effectively emit light in a comprehensive manner. The heat generated by the staggered LED chips 31 is dispersed without being concentrated together, thereby increasing the luminous efficiency and prolonging the service life of the LED chips 31.

Another advantage of the present invention is to use a driver board having a gallium nitride transistor. Because the gallium nitride transistor has the advantages of high efficiency, high frequency and low load cycle power conversion, the LED illuminating member has better illuminating performance and can reduce the size of its driver board. This makes the bulb design the same size as a conventional bulb without the limitation of the size of the driver board, such that the driver board can be installed in a conventional lamp. The heat insulation layer is used to fix the driver board in the bulb holder and block the heat energy generated when the LED illuminating member emits light, thereby prolonging the service life of the driver board.

Another advantage of the present invention is that the conductive adhesive is made by adding copper powder and palladium powder to high-temperature silica gel. The conductive adhesive is heated to bond the conductive pin to the transparent substrate, so that the conductive pin can be fixed very firmly on the transparent substrate without falling or breaking and can withstand a temperature of 170 degrees or higher.

Although particular embodiments of the present invention have been described in detail for purposes of illustration, various modifications and enhancements may be made without departing from the spirit and scope of the present invention. Accordingly, the present invention is not to be limited except as by the appended claims.

## Claims

1. An LED light bulb, comprising a housing (1), a bulb holder (2), at least one LED illuminating member (3) disposed in the housing (1) for comprehensive and effective illumination, and a driver board (4) that is disposed in the bulb holder (2) and has a gallium nitride transistor (41); **characterized in that**:
the housing (1) is a hollow sphere made of a light-permeable material; the bulb holder (2) is disposed at one end of the housing (1), the bulb holder (2) has an end portion (21) and a threaded portion (22) to form a positive terminal and a negative terminal for supplying power; the LED illuminating member (3) includes a plurality of LED chips (31) without reflectors, the LED chips (31) are arranged on a transparent substrate (34) in a staggering manner, a positive conductive wire (32) and a negative conductive wire (33) are disposed on the transparent substrate (34), the LED chips (31) and the positive conductive wire (32) are electrically connected to the negative conductive wire (33) through a plurality of wires (311), one end of each of the positive conductive wire (32) and the negative conductive wire (33) is connected to a conductive pin (37) that is fixed by a conductive adhesive (36) composed of high-temperature silica gel, copper powder and palladium powder, the conductive pin (37) is further electrically connected to the driver board (4); positive and negative power input portions of the driver board (4) are connected to the threaded section (22) and the end portion (21) of the bulb holder (2) through wires, when the bulb holder (2) is connected with a power source, the LED illuminating member (3) is driven by the driver board (4) to emit light.

2. The LED light bulb as claimed in claim 1, wherein one side of the driver board (4), corresponding to the LED illuminating member (3), is coated with a layer of heat dissipation adhesive to form a heat insulation layer (42), and an periphery of the heat insulation layer (42) fills a gap between the driver board (4) and an inner wall of the bulb holder (2).

3. The LED light bulb as claimed in claim 1, wherein a region of two surfaces of the transparent substrate (34), covered by the LED chips (31), is coated with an encapsulant (35) which can increase brightness.
